# EUROPEAN PATENT APPLICATION

(11) **EP 4 202 401 A1**
(43) Date of publication of application: **28.06.2023**
(21) Application number: 21875736.7
(22) Date of filing: 29.09.2021
(51) Int. Cl.: G01N 3/00, F16J 15/00, G06F 30/23

(54) **PREDICTING DEVICE, AND PREDICTING METHOD**

(30) Priority: 30.09.2020 JP 2020165218
(71) Applicant: Daikin Industries, Ltd., Osaka-shi, Osaka 530-0001 (JP)
(72) Inventor: LIU Jihong, Osaka-shi, Osaka 530-8323 (JP); AOYAMA Takahisa, Osaka-shi, Osaka 530-8323 (JP); TSUDA Hayato, Osaka-shi, Osaka 530-8323 (JP); SUKEGAWA Masamichi, Osaka-shi, Osaka 530-8323 (JP); TAKANEZAWA Satoru, Osaka-shi, Osaka 530-8323 (JP)
(74) Representative: Goddar, Heinz J.
(86) International application number: PCT/JP2021/035980
(87) International publication number: WO 2022/071439

(57) **Abstract**

A predicting method includes: a first step of outputting initial information indicating states of a structure and an object when the object is assembled to the structure, by simulating a process of assembling the object to the structure; and a second step of outputting first prediction information indicating future states of the structure and the object by simulating temporal change of assembly state where the object is assembled to the structure, using the initial information.

## Description

### TECHNICAL FIELD

The present disclosure relates to a predicting device and a predicting method.

### BACKGROUND ART

The method of predicting long-term properties of a gasket fastening body described in Patent Document 1 is a method of predicting future sealing performance of a gasket used for a pipe flange, a manhole of a pressure vessel, a bonnet of a valve, or the like. The method of predicting long-term properties of a gasket fastening body described in Patent Document 1 includes an environmental condition setting procedure of setting at least dimensions of the gasket fastening body, an initial stress on the gasket, a pressure condition and a temperature condition of an internal fluid, as input conditions for use in finite element analysis, and a material condition setting procedure of setting material conditions of the gasket fastening body as input conditions for use in finite element analysis.

### CITATION LIST

### PATENT DOCUMENT

Patent Document 1: Japanese Unexamined Patent Publication No. 2011-017392

### SUMMARY OF THE INVENTION

### TECHNICAL PROBLEM

However, a user has to set initial assembly state for the gasket by, for example, setting the initial stress on the gasket, setting the Young's modulus of the bolt based on the ratio between the sectional area of the actual pipe flange and the sectional area of the modeled pipe flange, and the like, which is complicated.

An object of the present disclosure is to easily predict the future states of a structure and an object.

### SOLUTION TO THE PROBLEM

A first aspect of the present disclosure is directed to a predicting method. The predicting method includes: a first step of outputting initial information indicating states of a structure and an object when the object is assembled to the structure, by simulating a process of assembling the object to the structure; and a second step of outputting first prediction information indicating future states of the structure and the object by simulating temporal change of assembly state where the object is assembled to the structure, using the initial information.

In the first aspect, future states of the structure and the object can be easily predicted.

A second aspect of the present disclosure is an embodiment of the first aspect. In the second aspect, the first prediction information includes information indicating states of the structure and the object when a predetermined period of time has elapsed since the object is assembled to the structure.

In the second aspect, a user can check the states of the structure and the object when a predetermined period of time has elapsed since the object is assembled to the structure.

A third aspect of the present disclosure is an embodiment of the first or second aspect. In the third aspect, the predicting method further includes: a third step of outputting second prediction information indicating future states of the structure and the object during application of a load to the structure and the object by simulating temporal change of an assembly state where the object is assembled to the structure, during application of the load to the object and the structure.

In the third aspect, the future states of the structure and the object can be predicted during application of a load to the structure and the object.

A fourth aspect of the present disclosure is an embodiment of any one of the first to third aspects. In the fourth aspect, in the first step, a simulation based on finite element analysis using at least one material model of an elastic body or an inelastic body is performed, and in the second step, a simulation based on finite element analysis using at least one material model of an elastic body or an inelastic body is performed.

In the fourth aspect, a simulation using at least one material model of an elastic body or an inelastic body can be performed in the first step, and a simulation using at least one material model of an elastic body or an inelastic body can be performed in the second step.

A fifth aspect of the present disclosure is an embodiment of the third aspect. In the fifth aspect, in the third step, a simulation based on finite element analysis using at least one material model of an elastic body or an inelastic body is performed.

In the fifth aspect, a simulation using at least one material model of an elastic body or an inelastic body can be performed in the third step.

A sixth aspect of the present disclosure is an embodiment of the fifth aspect. In the sixth aspect, in each of the simulations of the first step, the second step, and the third step, temperature dependency of the material model used is taken into account.

In the sixth aspect, a simulation in consideration of the temperature dependency of the material model can be performed.

A seventh aspect of the present disclosure is an embodiment of any one of the first to sixth aspects. In the seventh aspect, in the first step, a material model of an elastro-plastic body is used as the object, and in the second step, a material model of a creep deformable body is used as the object.

In the seventh aspect, a simulation using the material model of an elastro-plastic body as the object can be performed in the first step, and a simulation using the material model of a creep deformable body as an object can be performed in the second step.

An eighth aspect of the present disclosure is an embodiment of the seventh aspect. In the eighth aspect, in the first step or the second step, a material model of a rigid body is used as the structure.

In the eighth aspect, a simulation using the material model of a rigid body as the structure can be performed in the first step or the second step.

A ninth aspect of the present disclosure is an embodiment of any one of the first to sixth aspects. In the ninth aspect, in the first step, a material model of a superelastic body is used as the object, and in the second step, a material model of a viscoelastic body is used as the obj ect.

In the ninth aspect, a simulation using the material model of a superelastic body as the object can be performed in the first step, and a simulation using the material model of a viscoelastic body as the object can be performed in the second step.

A tenth aspect of the present disclosure is an embodiment of the ninth aspect. In the tenth aspect, in the first step or the second step, a material model of a rigid body is used as the structure.

In the tenth aspect, a simulation using the material model of a rigid body as the structure can be performed in the first step or the second step.

An eleventh aspect of the present disclosure is an embodiment of any one of the first to tenth aspects. In the eleventh aspect, a material of the object is a macromolecule.

In the eleventh aspect, the object can be made of a macromolecule.

A twelfth aspect of the present disclosure is an embodiment of the eleventh aspect. In the twelfth aspect, the macromolecule is a fluorine resin or a fluorine rubber.

In the twelfth aspect, the macromolecule can be a fluorine resin or a fluorine rubber.

A thirteenth aspect of the present disclosure is an embodiment of any one of the first to twelfth aspects. In the thirteenth aspect, a material of the structure is a metal, ceramics, or a macromolecule.

In the thirteenth aspect, the structure can be made of metal, ceramics, or a macromolecule.

A fourteenth aspect of the present disclosure is an embodiment of any one of the third, fifth, and sixth aspects. In the fourteenth aspect, in each of the first step, the second step, and the third step, a material model of a rigid body is used as the structure.

In the fourteenth aspect, the material model of a rigid body can be used as the structure in each of the first step, the second step, and the third step.

A fifteenth aspect of the present disclosure is an embodiment of any one of the first to fourteenth aspects. In the fifteenth aspect, the object is a gasket, a pipe, a joint, a pump, or a valve.

In the fifteenth aspect, the object can be a gasket, a pipe, a joint, a pump, or a valve.

A sixteenth aspect of the present disclosure is directed to a predicting device. The predicting device includes: a first processor (14a) configured to output initial information indicating states of a structure and an object when the object is assembled to the structure, by simulating a process of assembling the object to the structure; and a second processor (14b) configured to output first prediction information indicating future states of the structure and the object by simulating temporal change of assembly state where the object is assembled to structure, using the initial information.

In the sixteenth aspect, the future states of the structure and the object can be easily predicted.

### BRIEF DESCRIPTION OF THE DRAWINGS

FIG. 1 is a block diagram illustrating a configuration of a predicting device according to an embodiment of the present invention.
FIG. 2 is a sectional view of a sealing structure of a lithium ion battery.
FIG. 3 is a partially enlarged view of the sealing structure shown in FIG. 2.
FIG. 4 is a flowchart illustrating operation of a controller.
FIG. 5 is a flowchart illustrating first processing.
FIG. 6 is a flowchart illustrating second processing.
FIG. 7 is a flowchart illustrating third processing.

### DESCRIPTION OF EMBODIMENTS

Embodiments of the present invention will be described in detail with reference to the drawings. Note that like reference characters denote the same or equivalent components in the drawings, and the detailed description thereof, the description of advantages associated therewith, and other descriptions will not be repeated.

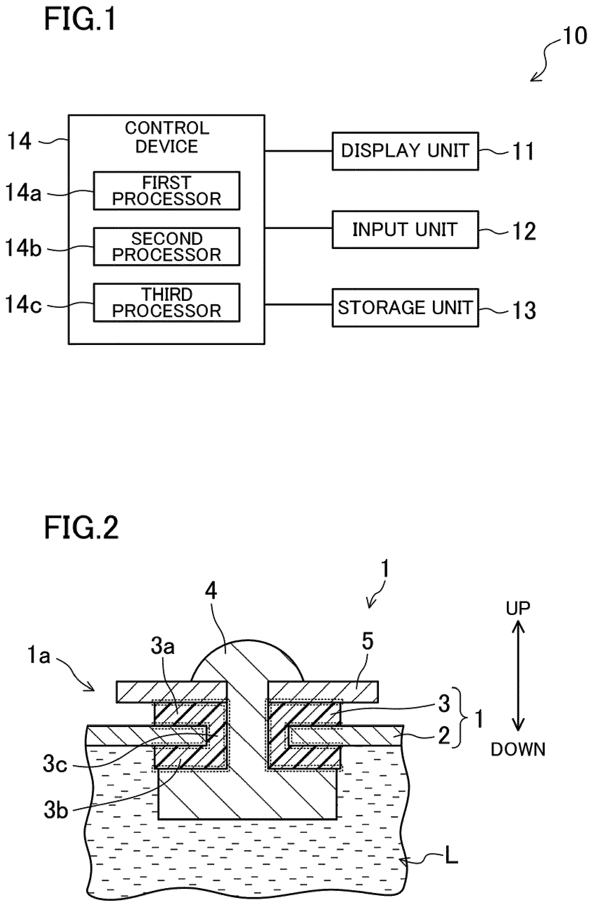

A predicting device (10) according to an embodiment of the present invention will be described with reference to FIG. 1. FIG. 1 is a block diagram illustrating a configuration of the predicting device (10) according to an embodiment of the present invention.

### -General Configuration-

As illustrated in FIG. 1, the predicting device (10) predicts a future assembly state of an object to a structure. Examples of the material of the object include a macromolecule (preferably, a polymer). Examples of the macromolecule include resin (such as a fluorine resin) and rubber (such as a fluorine rubber). Examples of the object include a gasket, a pipe, a joint, a pump, and a valve. Examples of the material of the structure include metals, ceramics, and macromolecules (preferably, polymers). The type of the structure is not limited as long as it is a structure to which the object is assembled.

Being assembled indicates that the object is placed in position with respect to the structure so that the object is held in contact with the structure while receiving pressure from the structure. For example, the object and the structure are coupled by compression, bending, crimping, or the like, whereby the object is assembled to the structure. For example, in the state where the object is assembled to the structure, a structure product including the object and the structure is used as a product.

The predicting device (10) is, for example, a personal computer (PC). The predicting device (10) includes a display unit (11), an input unit (12), a storage unit (13), and a control device (14).

The display unit (11) includes, for example, a display and is configured to display information. The input unit (12) receives an input of an instruction to the predicting device (10) from outside. Examples of the input unit (12) include a keyboard, a mouse, and a touch panel. The storage unit (13) includes a main memory (e.g., a semiconductor memory), such as a flash memory, a read only memory (ROM), and a random access memory (RAM), and may further include an auxiliary memory (e.g., a hard disk drive, a solid state drive (SSD), a secure digital (SD) memory card, or a universal serial bus (USB) flash memory). The storage unit (13) stores various computer programs executable by the control device (14).

The control device (14) includes a processor, such as a central processing unit (CPU) or a microprocessor unit (MPU). The control device (14) executes the computer programs stored in the storage unit (13) to control elements of the predicting device (10). The control device (14) includes a first processor (14a), a second processor (14b), and a third processor (14c). The control device (14) functions as the first processor (14a), the second processor (14b), and the third processor (14c) by executing the computer programs stored in the storage unit (13).

### -Lithium Ion Battery-

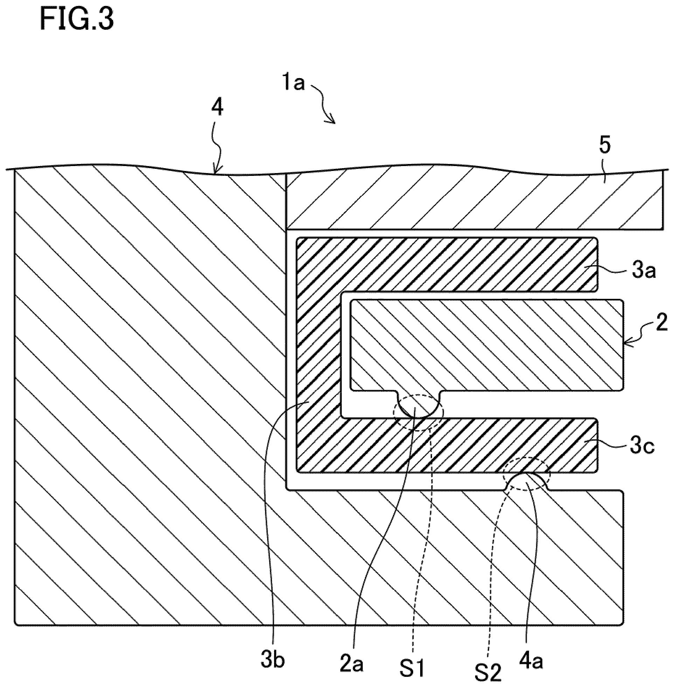

Examples of the structure and the object will be described with reference to FIGS. 2 and 3. FIG. 2 is a sectional view of a sealing structure (1a) of a lithium ion battery (1). FIG. 3 is a partially enlarged view of the sealing structure (1a) shown in FIG. 2.

As illustrated in FIGS. 2 and 3, the lithium ion battery (1) includes the sealing structure (1a) and an electrode (4). The sealing structure (1a) includes a lid (2) and a gasket (3).

The electrode (4) is a first example of the structure. The lid (2) is a second example of the structure. The gasket (3) is an example of the object.

The lid (2) is made of, for example, metal such as aluminum. The gasket (3) is, for example, a gasket (3) for lithium ion secondary batteries (LIBs). The raw material of the gasket (3) is, for example, a fluoric resin, more specifically, a copolymer of tetrafluoroethylene and perfluoroalkyl vinyl ether (PFA for short). The electrode (4) is made of an electrically conductive metal.

The gasket (3) has a substantially tubular shape with an upper portion (3a) and a lower portion (3c) protruding radially outward. The lid (2) has a substantially circular shape. The lid (2) is placed between the upper portion (3a) and the lower portion (3c) of the gasket (3), and surrounds the outer side of a vertically middle portion (3b) of the gasket (3). A washer (5) is placed above the upper portion (3a) of the gasket (3). The lid (2), the gasket (3), and the washer (5) are held by the electrode (4).

In the lithium ion battery (1), the sealing structure (1a) is sandwiched between the washer (5) and the electrode (4). In the lithium ion battery (1), an electrolyte (L) encapsulated in a casing (not shown) of the lithium ion battery (1) is sealed by the sealing structure (1a). The sealing structure (1a) prevents moisture in the atmosphere from flowing into the casing of the lithium ion battery (1).

In the sealing structure (1a), the gasket (3) is interposed between the electrode (4) and the lid (2) to prevent the electrode (4) and the lid (2) from coming into contact with each other (see FIGS. 2 and 3). The PFA employed as the raw material of the gasket (3) has insulating properties. The gasket (3) has a function of electrically insulating the lid (2) from the electrode (4).

The sealing structure (1a) provides sealing on two sealing surfaces. One of these sealing surfaces is a first contact portion (S1). The other sealing surface is a second contact portion (S2). The first contact portion (S1) indicates a portion where a projection (2a) provided on the lid (2) is in contact with the gasket (3). The lid (2) is brought into contact with the gasket (3) by the projection (2a), thereby applying a pressure to the gasket (3). The second contact portion (S2) is a portion where a projection (4a) provided in the electrode (4) is in contact with the gasket (3). The electrode (4) is brought into contact with the gasket (3) by the projection (4a), thereby applying a pressure to the gasket (3). The projections (2a), (4a) come into contact with the gasket (3) so as to sandwich the gasket (3) from above and below.

The gasket (3) comes into contact with the lid (2) and the electrode (4) while receiving the pressure from the lid (2) (the first contact portion (S1)) and the electrode (4) (the second contact portion (S2)). Thus, the gasket (3), which is an object, is assembled to the lid (2) and the electrode (4), which are structures.

Hereinafter, the pressure generated in the first contact portion (S1) (the repulsive force acting on the lid (2) from the gasket (3)) and the pressure generated in the second contact portion (S2) (the repulsive force acting on the electrode (4) from the gasket (3)) may be collectively referred to as sealing surface pressure.

In the present embodiment, the gasket (3), which is an object, is compressed and assembled to the lid (2) and the electrode (4), which are structures, so that the sealing surface pressure is generated.

In the sealing structure (1a), the gasket (3) is assembled to the lid (2) and the electrode (4) by the sealing surface pressure generated in the first contact portion (S1) and the second contact portion (S2). In the present embodiment, the gasket (3) is made of a resin. This reduces the sealing surface pressure with time due to creep properties after the gasket (3) is assembled to the lid (2) and the electrode (4).

The control device (14) simulates a change in the state of the structures and the object in the future, such as a decrease in the sealing surface pressure with time.

### -Operation of Control Device-

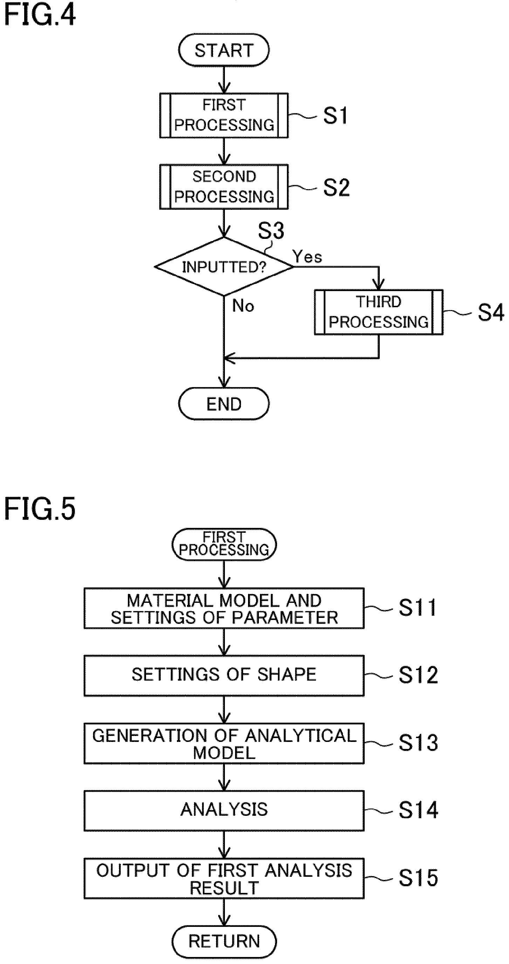

Next, operation of the control device (14) will be described with reference to FIGS. 1 and 4. FIG. 4 is flowchart illustrating the operation of the control device (14).

The control device (14) performs processes shown in the flowchart of FIG. 4 by executing a commercially available program (general-purpose program) of finite element method such as ANSYS (registered trademark) or a dedicated program.

As illustrated in FIGS. 1 and 4, in Step S1, the first processor (14a) of the control device (14) performs first processing. The first processing is a process of simulating a process of assembling the object to the structures. In the first processing, a simulation based on finite element analysis using at least one material model of an elastic body or an inelastic body is performed. The elastic body includes a superelastic body and a viscoelastic body. Examples of the inelastic body include an elastro-plastic body, a visco-plastic body, a creep deformable body (an object having a property of deformation by creep) and a rigid body. In the present embodiment, in the first processing, a simulation based on finite element analysis using a material model in which an elastro-plastic body is used as a gasket (3), which is an object, and a rigid body is used as the lid (2) and the electrode (4), which are structures.

In Step S2, the second processor (14b) of the control device (14) performs second processing. The second processing is a process of simulating temporal change of the states of the structures and the object after assembling. In the second processing, a simulation based on finite element analysis using at least one material model of an elastic body or an inelastic body is performed. In the present embodiment, in the second processing and third processing to be described later, a simulation based on finite element analysis using a material model in which an elastro-plastic body and a creep deformable body are used as a gasket (3), which is an object, and a rigid body is used as the lid (2) and the electrode (4), which are structures.

In Step S3, the third processor (14c) of the control device (14) determines whether or not the input unit (12) has received information indicating that the third processing is to be performed. The third processing is a process of simulating temporal change of the states of the structures and the object after assembling during application of a load to the structure and the obj ect.

If the third processor (14c) determines that the input unit (12) has received information indicating that the third processing is to be performed (Yes in Step S3), the process goes to Step S4. If the third processor (14c) determines that the input unit (12) has not received the information indicating that the third processing is to be performed (No in Step S3), the process ends.

In Step S4, the third processor (14c) performs the third processing. In the third processing, a simulation based on finite element analysis using at least one material model of an elastic body or an inelastic body is performed. When the process shown in Step S4 ends, the process ends.

For example, in the first processing, the material model of a rigid body may be used as structures, and a material model of elastro-plastic body may be used as an object, and in the second processing, the material model of a rigid body may be used as structures, and a material model of a creep deformable body may be used as an object. In this case, in the second processing, when the force applied to the object is redistributed due to creep deformation of the object, the material model of an elastro-plastic body may be used as the object. In other words, the material model of a creep deformable body and the material model of an elastro-plastic body may be used as the object. In the first processing, the material model of a rigid body may be used as structures, and a material model of a superelastic body may be used as an object, and in the second processing, the material model of a rigid body may be used as structures, and a material model of the viscoelastic body may be used as an object. In each of the first step, second step, and third step, a material model of a rigid body may be used as structures.

The first processing (see FIG. 4) will be described with reference to FIGS. 1 and 5. FIG. 5 is a flowchart illustrating the first processing.

As illustrated in FIGS. 1 and 5, in Step S11, the input unit (12) receives an input of information indicating material models of the object and the structures and information on settings of parameters. The information on the settings of parameters includes information indicating the states of the object and the structures in the assembly process of assembling the object to the structures. The information on the settings of parameters include, for example, at least one of information indicating coefficients of friction of contact portions between the object and the structures (the first contact portion (S1) and the second contact portion (S2) shown in FIG. 3) or information indicating a forced displacement amount of the object due to being compressed and assembled to the structures.

In Step S12, the input unit (12) receives input of information indicating settings of shape. The information indicating the settings of shape includes information indicating shapes and dimensions of the object and the structures.

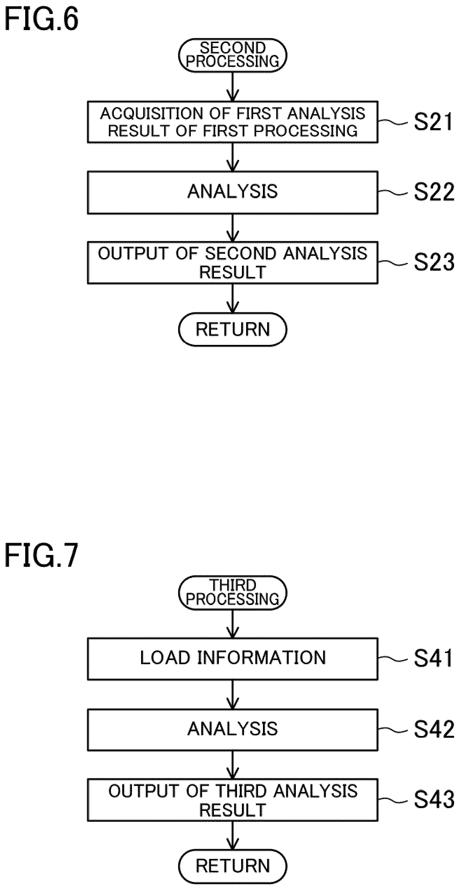

For example, in the sealing structure (1a), the lid (2) and the electrode (4) have a projection (2a) and a projection (4a), respectively, and the sealing function is ensured by the projections (2a), (4a) (see FIG. 3). In Step S22 to be described later (see FIG. 6), in order to accurately analyze future sealing surface pressure, it is preferable to clarify the shapes and dimensions of the projections (2a), (4a) where the sealing surface pressure is generated. Thus, information indicating the shapes and dimensions of the projections (2a), (4a), i.e., information indicating the shapes and dimensions of the contact portions between the object and the structures, is input from the input unit (12).

In Step S13, the first processor (14a) generates analytical models of the object and the structures based on each piece of information (information indicating material models, information on the settings of parameters, and information indicating the settings of shape) received by the input unit (12) in Step S11 and Step S12.

In Step S14, the first processor (14a) performs a simulation of an assembly process where the object is assembled to the structures (assembly simulation).

In Step S15, the first processor (14a) outputs a first analysis result, which is a result of the simulation in Step S14. The first analysis result includes initial information including physical quantities indicating the states of the structures and the object when the object is assembled to the structures (initial assembly). The first analysis result (initial information) includes, for example, at least one of information (initial stress information) indicating a stress (initial stress) on the object, information (initial distortion information) indicating a distortion (initial distortion) on the object, information (initial displacement information) indicating displacement of the object to the structures, or information indicating an assembly state where object is assembled to the structures (initial assembly information). The initial assembly information includes, for example, information (initial sealing surface pressure information) indicating a sealing surface pressure in initial assembly.

When the process shown in Step S15 ends, the process goes to Step S2 shown in FIG. 4.

Next, the second processing will be described with reference to FIGS. 1 and 6. FIG. 6 is a flowchart illustrating second processing.

As illustrated in FIGS. 1 and 6, in Step S21, the second processor (14b) acquires information indicating the first analysis result of the first processing (see Step S15 in FIG. 5). Then, the input unit (12) receives an input of the information indicating material models of the object and the structures. At this time, the input unit (12) also receives an input of information indicating change with time, of material physical properties of the object and the structures. The change with time, of material physical properties indicates, for example, information on physical properties related to deformation, such as creep deformation properties. The input unit (12) receives an input of the assembly information of the object and the structures (such as a forced displacement amount of the object due to compression in assembly). The input unit (12) may be configured to input information indicating retightening of an object if (e.g., in a joint and a joint assembly) the object after assembly comes loose (e.g., in a case where the object is a joint of a pipe for allowing a chemical solution to flow therethrough in a semiconductor device, the joint after assembly comes loose) and the object is retightened. For example, when information indicating retightening is input from the input unit (12), the second processor (14b) determines the initial stress of the object again by a simulation in consideration of retightening. Accordingly, the initial stress is reset, and the reset initial stress is used instead of the initial stress output in Step S15 of the first processing when processes in Step S22 and subsequent steps are performed. As illustrated in FIGS. 2 and 3, when the object is a gasket (3), the forced displacement amount of the gasket (3) may be set to 0 on the assumption that the gasket (3) is not loosened after the gasket (3) is assembled.

In Step S22, the second processor (14b) performs a simulation of temporal change of the states of the structures and the object after assembly by using various pieces of information acquired in Step S21 (temporal property simulation).

In Step S23, the second processor (14b) outputs a second analysis result, which is a result of the simulation in Step S22. The second analysis result includes first prediction information indicating future states of the structures and the object. The second analysis result (first prediction information) includes, for example, at least one of information (first prediction stress information) indicating stress on the object, information (first prediction distortion information) indicating a distortion on the object, information (first prediction displacement information) indicating displacement of the object to the structures, or information (first prediction assembly information) indicating an assembly state where the object is assembled to the structures, when a predetermined period of time has elapsed since the object is assembled to the structures. The first prediction assembly information includes, for example, information (first prediction sealing surface pressure information) indicating a sealing surface pressure when a predetermined period of time has elapsed.

In the second analysis result, the predetermined period of time can be set, as appropriate, by the user using the input unit (12), for example. For example, by setting the predetermined period of time to 10 years, various pieces of information are output as the second analysis result when 10 years has elapsed since the object is assembled.

When the process shown in Step S23 ends, the process goes to Step S3 shown in FIG. 4.

Next, the third processing will be described with reference to FIGS. 1 and 7. FIG. 7 is a flowchart illustrating third processing.

As illustrated in FIGS. 1 and 7, in Step S41, the input unit (12) receives an input of load information. The load information is information indicating a load pressure on the object and the structures. The load pressure is a pressure different from the pressure (sealing surface pressure) generated in assembling of the object to the structures. For example, in a lithium ion battery (1) shown in FIGS. 2 and 3, the load pressure is generated when a sudden load is generated on the gasket (3), the electrode (4), and the like due to internal gas generation and the like. The load pressure may cause the object to be in non-contact with the structures or the contact surface pressure (sealing surface pressure) between the object and the structures to be small. Therefore, the load pressure affects the second analysis result (see Step S23 in FIG. 6). Thus, the third processing is performed in the event of generation of the load pressure.

Then, in Step S41, the third processor (14c) acquires a second analysis result. In the third processing, the material models of the object and the structures set in the second processing are used.

In Step S42, the third processor (14c) simulates temporal change of the states of the structures and the object during the application of the load by using various pieces of information acquired in Step S41 (temporal property simulation during application of load).

In Step S43, the third processor (14c) outputs a third analysis result, which is a result of the simulation in Step S42. The third analysis result is obtained by correcting the second analysis result shown in FIG. 6 to a value in consideration of the load pressure. The third analysis result includes second prediction information indicating future states of the structures and the object during application of the load to the structures and the object. The third analysis result (second prediction information) includes, for example, at least one of information (second prediction stress information) indicating stress generated on the object, information (second prediction distortion information) indicating a distortion on the object, information (second prediction displacement information) indicating displacement of the object to the structures, or information (second prediction assembly information) indicating an assembly state where object is assembled to the structures, when a predetermined period of time has elapsed since the object is assembled to the structures during application of the load to the object and the structures. The second prediction assembly information includes, for example, information (second prediction sealing surface pressure information) indicating a sealing surface pressure when a predetermined period of time has elapsed during application of the load to the object and the structures.

When the process shown in Step S43 ends, the process ends (see FIG. 4).

### -Summary of First Processing to Third Processing-

In this embodiment, in the first processing shown in FIG. 5, the first processor (14a) simulates the assembly process where the object is assembled to the structures to output a first analysis result. The first analysis result clarifies the initial information (such as the initial stress information, the initial distortion information, the initial displacement information, and the initial sealing surface pressure information) indicating the initial assembly state where the object is assembled to the structures.

In the second processing shown in FIG. 6, the second processor (14b) simulates temporal change of the states of the object and the structures after assembly based on the initial information to output a second analysis result. Information (such as the first prediction stress information, the first prediction distortion information, the first prediction displacement information, and the first prediction sealing surface pressure information) indicating future states of the structures and the object are output as the second analysis result. For example, a maximum sealing surface pressure and a maximum main distortion when 10 years have elapsed since the gasket (3) is assembled to the lid (2) and the electrode (4) are output as the second analysis result (see FIGS. 2 and 3). The maximum sealing surface pressure is the lowest one of maximum sealing surface pressures generated on the first contact portion (S1) and the second contact portion (S2). The maximum main distortion is a maximum value of distortion generated on the gasket (3).

In the third processing shown in FIG. 7, the third processor (14c) outputs a third analysis result by simulating how the properties related to the assembly state where the object is assembled to the structures temporally change when the load pressure is acting. Information (such as the second prediction stress information, the second prediction distortion information, the second prediction displacement information, and the second prediction sealing surface pressure information) indicating the future states of the structures and the object in consideration of the load pressure is output as the third analysis result. As a result, for example, in the lithium ion battery (1) shown in FIGS. 2 and 3, even when the internal pressure rapidly changes due to the load pressure, a simulation can be performed in consideration of the load pressure. As a result, in the lithium ion battery (1), it is possible to accurately predict whether or not the sealing surface pressure can be ensured in the future.

### -Advantages of Examples-

As can be seen from the description made above with reference to FIGS. 1 to 7, a process of assembling the object to the structure in the first processing (see FIG. 5) is simulated to output initial information (such as the initial stress information, the initial distortion information, the initial displacement information, and the initial sealing surface pressure information) indicating the states of the structure and the object at the time of assembly of the object. Then, in the second processing (see FIG. 6), the future states of the structure and the object are predicted by using the initial information. Therefore, the user does not need to set the initial information by themselves, so that the future states of the structure and the object can be easily predicted.

In Step S12 of the first processing, in setting the shapes of the object and the structures from the input unit (12), information indicating complex shapes and dimensions of the object and the structures such as the shapes and dimensions of the projections (2a), (4a) (see FIG. (3)) may be input. This allows the simulations of the second processing and the third processing to take into account the complex shapes and dimensions of the object and structures. As a result, the accuracy of the second analysis result output in the second processing and the accuracy of the third analysis result output in the third processing can be improved.

Since the simulation (first processing) of the process of assembling the object to the structures, the simulation (second processing) of temporal change in assembly state where the object is assembled to the structures, and the simulation (third processing) in consideration of the load pressure can be performed successively, the process (e.g., the process of predicting a future sealing surface pressure in the lithium ion battery (1) and the like) can be performed promptly.

While the embodiments and the variations thereof have been described above, it will be understood that various changes in form and details may be made without departing from the spirit and scope of the claims (e.g., (1) to (5) below). The embodiments and the variations thereof may be combined and replaced with each other without deteriorating intended functions of the present disclosure.
(1) In the first processing to the third processing shown in FIG. 4, when the object is made of a rubber material, a material model of a superelastic body may be used as the object in the first processing, and a material model of a viscoelastic body may be used as the object in the second processing and the third processing. In such a case, in each of the first processing to the third processing, a material model of a rigid body may be used as the structures.
(2) The second analysis result (see Step S23 in FIG. 6) and the third analysis result (see Step S43 in FIG. 7) may each be displayed on the display unit (11) (see FIG. 1). As a result, the user can check each of the second analysis result and the third analysis result from the display unit (11).
(3) In the simulation of each of the first processing (see FIG. 5), the second processing (see FIG. 6), and the third processing (see FIG. 7), the temperature dependency of the material models used may be taken into account. For example, if the gasket (3) as the object has temperature dependency according to which the rigidity decreases as the temperature increases during an increase in the stress, the temperature dependency of the compression properties of the gasket (3) is taken into account in setting the material model of the gasket (3) in the simulations. In addition, in the case where the coefficient of linear expansion and the specific heat of the gasket (3) as an object and the thermal conductivity have temperature dependency, the temperature dependency of the coefficient of linear expansion and the specific heat of the gasket (3) and the thermal conductivity are taken into account in setting the material model of the gasket (3) in the simulations.
(4) In the present embodiment, the predicting device (10) performs the first processing to the third processing (see FIGS. 4 to 7) to perform a long-term reliability evaluation (prediction of the future state) of the gasket (3) for lithium ion secondary batteries.
   However, the present invention is not limited to this. The predicting device (10) may evaluate the long-term reliability of an object such as a bellows pump, a diaphragm pump, a diaphragm valve, a pipe joint (e.g., for allowing a chemical solution to flow therethrough in a semiconductor device), or various macromolecule products. The evaluation result can then be analyzed to optimize the design of the object.
(5) In a joint assembly configured by coupling and fixing a joint to a tube (pipe) as shown in Japanese Patent No. 5858195, the long-term reliability of the joint and the joint assembly may be evaluated by performing the first processing to the third processing (see FIGS. 4 to 7) with the j oint as the object and the tube (pipe) as the structure. If the j oint assembled to the tube (pipe) by coupling and fixing the joint to the tube (pipe) is retightened, and information indicating retightening of the joint is input from the input unit (12) in Step S21 of the second processing, the second processor (14b) may again determine the initial stress of the joint by a simulation in consideration of the retightening.

### INDUSTRIAL APPLICABILITY

As can be seen from the foregoing description, the present disclosure is useful for a predicting device and a predicting method.

### DESCRIPTION OF REFERENCE CHARACTERS

- 1: Lithium Ion Battery
- 1a: Sealing Structure
- 2: Lid (Structure)
- 3: Gasket (Object)
- 4: Electrode (Structure)
- 10: Predicting Device
- 14: Control Device
- 14a: First Processor
- 14b: Second Processor
- 14c: Third Processor

## Claims

1. A predicting method comprising:
a first step of outputting initial information indicating states of a structure and an object when the object is assembled to the structure, by simulating a process of assembling the object to the structure; and
a second step of outputting first prediction information indicating future states of the structure and the object by simulating temporal change of assembly state where the object is assembled to the structure, using the initial information.

2. The predicting method of claim 1, wherein
the first prediction information includes information indicating states of the structure and the object when a predetermined period of time has elapsed since the object is assembled to the structure.

3. The predicting method of claim 1 or 2, further comprising:
a third step of outputting second prediction information indicating future states of the structure and the object during application of a load to the structure and the object by simulating temporal change of an assembly state where object is assembled to the structure, during application of the load to the object and the structure.

4. The predicting method of any one of claims 1 to 3, wherein
in the first step, a simulation based on finite element analysis using at least one material model of an elastic body or an inelastic body is performed, and
in the second step, a simulation based on finite element analysis using at least one material model of an elastic body or an inelastic body is performed.

5. The predicting method of claim 3, wherein
in the third step, a simulation based on finite element analysis using at least one material model of an elastic body or an inelastic body is performed.

6. The predicting method of claim 5, wherein
in each of the simulations of the first step, the second step, and the third step, temperature dependency of the material model used is taken into account.

7. The predicting method of any one of claims 1 to 6, wherein
in the first step, a material model of an elastro-plastic body is used as the object, and in the second step, a material model of a creep deformable body is used as the object.

8. The predicting method of claim 7, wherein
in the first step or the second step, a material model of a rigid body is used as the structure.

9. The predicting method of any one of claims 1 to 6, wherein
in the first step, a material model of a superelastic body is used as the object, and in the second step, a material model of a viscoelastic body is used as the object.

10. The predicting method of claim 9, wherein
in the first step or the second step, a material model of a rigid body is used as the structure.

11. The predicting method of any one of claims 1 to 10, wherein
a material of the object is a macromolecule.

12. The predicting method of claim 11, wherein
the macromolecule is a fluorine resin or a fluorine rubber.

13. The predicting method of any one of claims 1 to 12, wherein
a material of the structure is metal, ceramics, or a macromolecule.

14. The predicting method of any one of claims 3, 5, and 6, wherein
in each of the first step, the second step, and the third step, a material model of a rigid body is used as the structure.

15. The predicting method of any one of claims 1 to 14, wherein
the object is a gasket, a pipe, a joint, a pump, or a valve.

16. A predicting device comprising:
a first processor (14a) configured to output initial information indicating states of a structure and an object when the object is assembled to the structure, by simulating a process of assembling the object to the structure; and
a second processor (14b) configured to output first prediction information indicating future states of the structure and the object by simulating temporal change of assembly state where the object is assembled to the structure, using the initial information.
